# EUROPEAN PATENT APPLICATION

(11) **EP 4 580 318 A1**
(43) Date of publication of application: **02.07.2025**
(21) Application number: 22956405.9
(22) Date of filing: 22.08.2022
(51) Int. Cl.: H05H 1/34

(54) **PLASMA GENERATION DEVICE**

(71) Applicant: Fuji Corporation, Chiryu-shi, Aichi 472-8686 (JP)
(72) Inventor: IKEDO, Toshiyuki, Chiryu-shi, Aichi 472-8686 (JP)
(74) Representative: Grünecker Patent- und Rechtsanwälte PartG mbB
(86) International application number: PCT/JP2022/031531
(87) International publication number: WO 2024/042577

(57) **Abstract**

A plasma generation device includes one electrode, a case made of a conductor and having a cylindrical internal space, a nozzle made of a conductor, installed rotatably about a central axis of the internal space of the nozzle case, and configured to eject generated plasma gas, a fluid supply device configured to supply a fluid into the internal space, a rotation mechanism made of an insulator and configured to rotate the nozzle by the fluid supplied from the fluid supply device, a conductive path formed between the nozzle case and the nozzle, and a power supply configured to apply a voltage to the electrode, in which the nozzle case is grounded, and the plasma gas is generated by a potential difference between the electrode to which a voltage is applied by the power supply and the nozzle grounded by the conductive path.

## Description

### Technical Field

The present disclosure relates to a plasma generation device that generates plasma under atmospheric pressure.

### Background Art

Patent Literature 1 describes a plasma nozzle that has a casing having a portion with an increased diameter at an upper portion thereof and that is held by a bearing to be rotatable with respect to a fixed support tube at the upper portion with an increased diameter. A ceramic pipe is inserted into the fixed support tube, and a spiral system having an electrode is inserted into the ceramic pipe. A high frequency alternating current is supplied to the electrode. The casing is made of metal, is grounded via the bearing and the fixed support tube, and functions as a counter electrode, and arc discharge is generated between the electrode and the casing.

### Citation List

### Patent Literature

Patent Literature 1:JP-A-2001-68298

### Summary of the Invention

### Technical Problem

However, in the plasma nozzle disclosed in Patent Literature 1, since a current also flows through the bearing as described above, bearing damage, lubrication deterioration, or the like may be generated or advance in the bearing due to electrolytic corrosion, and as a result, there is a concern that the product lifespan may be shortened.

An object of the present disclosure is to provide a technique capable of extending a product lifespan.

### Solution to Problem

In order to achieve the above object, a plasma generation device according to an embodiment of the present disclosure includes one electrode, a nozzle case made of a conductor and having a cylindrical internal space, a nozzle made of a conductor, installed rotatably about a central axis of the internal space of the nozzle case, and configured to eject generated plasma gas, a fluid supply device configured to supply a fluid into the internal space, a rotation mechanism made of an insulator and configured to rotate the nozzle by the fluid supplied from the fluid supply device, a conductive path formed between the nozzle case and the nozzle, and a power supply configured to apply a voltage to the electrode, in which the nozzle case is grounded, and the plasma gas is generated by a potential difference between the electrode to which a voltage is applied by the power supply and the nozzle grounded by the conductive path.

### Advantageous Effects of Invention

According to the present disclosure, it is possible to extend the product lifespan.

### Brief Description of Drawings

Fig. 1 is a block diagram illustrating a schematic configuration of a plasma generation device according to an embodiment of the present application.
Fig. 2 is a perspective view illustrating an appearance of a plasma generator provided in the plasma generation device of Fig. 1.
Fig. 3 is a partial cross-sectional view of the plasma generator taken along line A-A in Fig. 2.
Fig. 4 is a partial cross-sectional view of the plasma generator taken along line B-B in Fig. 2.
Fig. 5 is a perspective view illustrating components installed in a nozzle case included in the plasma generator of Fig. 2.
Fig. 6 is an enlarged partial cross-sectional view illustrating the nozzle case and a vicinity thereof included in the plasma generator of Fig. 3 in an enlarged manner.
Fig. 7 is a diagram illustrating a structure in which a nozzle installed in the nozzle case of Fig. 5 rotates.
Fig. 8 is an enlarged perspective view illustrating a contact plate attached to a blade section installed in the nozzle case of Fig. 5 in an enlarged manner.

### Description of Embodiments

Hereinafter, embodiments of the present disclosure will be described in detail with reference to the drawings.

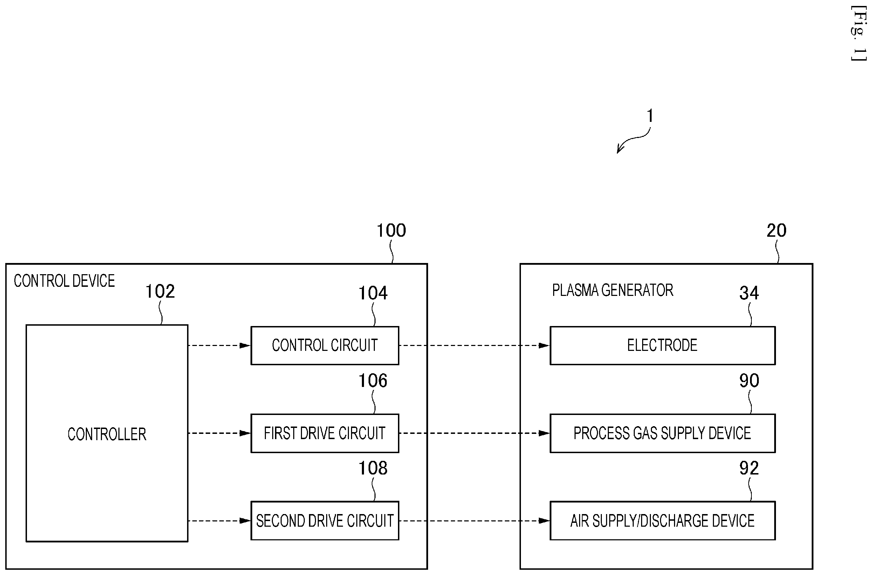

Fig. 1 illustrates a schematic configuration of plasma generation device 1 according to a first embodiment of the present application. Plasma generation device 1 of the present embodiment generates plasma gas under atmospheric pressure, and performs plasma process on a process target object by injecting the plasma gas to the process target object.

As illustrated in Fig. 1, plasma generation device 1 is mainly configured with plasma generator 20 that generates plasma gas and control device 100 that controls plasma generator 20.

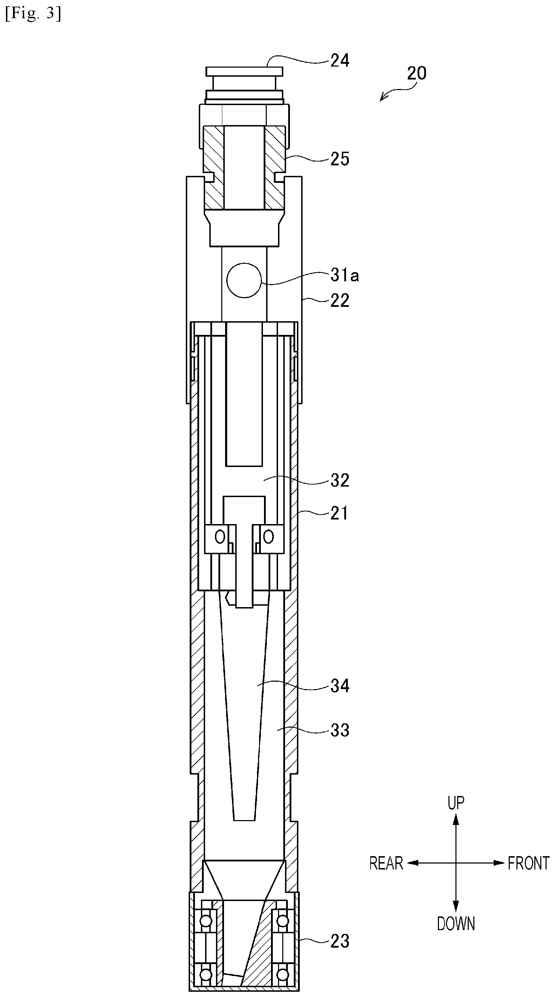

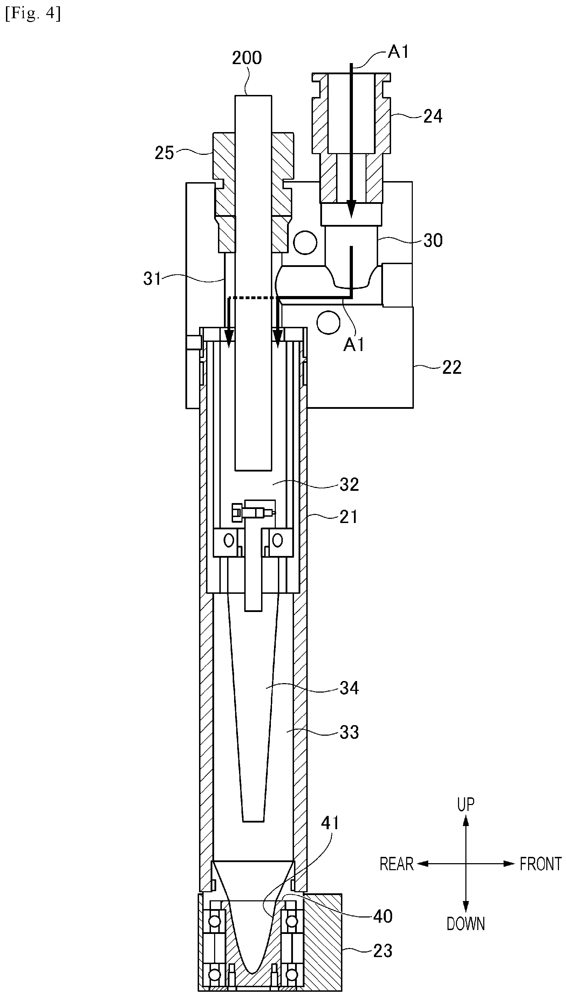

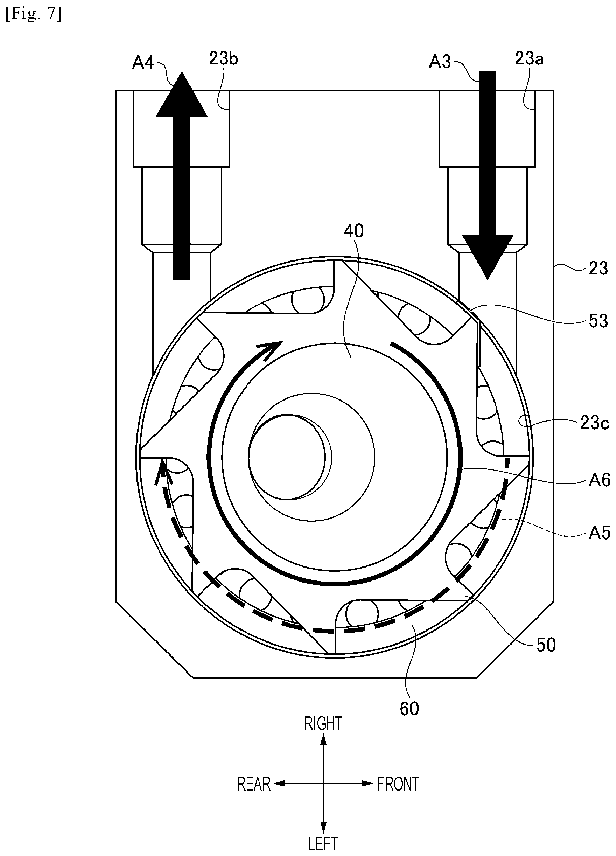

Plasma generator 20 includes electrode 34, process gas supply device 90, and air supply/discharge device 92. Process gas supply device 90 supplies process gas serving as a base of the plasma gas to gas passage 30 (see Fig. 4) to be described later. The process gas is obtained by mixing inert gas such as rare gas or nitrogen gas with active gas such as oxygen at a predetermined ratio. Electrode 34 is provided in reaction chamber 33 (see Fig. 3) described later, and generates a pseudo arc in reaction chamber 33. The process gas is converted into plasma when passing through the pseudo arc, becoming plasma gas. Air supply/discharge device 92 supplies air to air supply port 23a formed in nozzle case 23 described later with reference to Fig. 7, and discharges air from air discharge port 23b formed in nozzle case 23.

Control device 100 includes controller 102 that is mainly configured with a computer, control circuit 104 that controls electrode 34, first drive circuit 106 that drives process gas supply device 90, and second drive circuit 108 that drives air supply/discharge device 92.

Controller 102 controls the voltage applied to electrode 34 by controlling control circuit 104. Further, controller 102 controls the supply amount of the process gas supplied by process gas supply device 90, by controlling first drive circuit 106. Further, controller 102 controls the supply amount and the discharge amount of the air supplied and discharged by air supply/discharge device 92, by controlling second drive circuit 108.

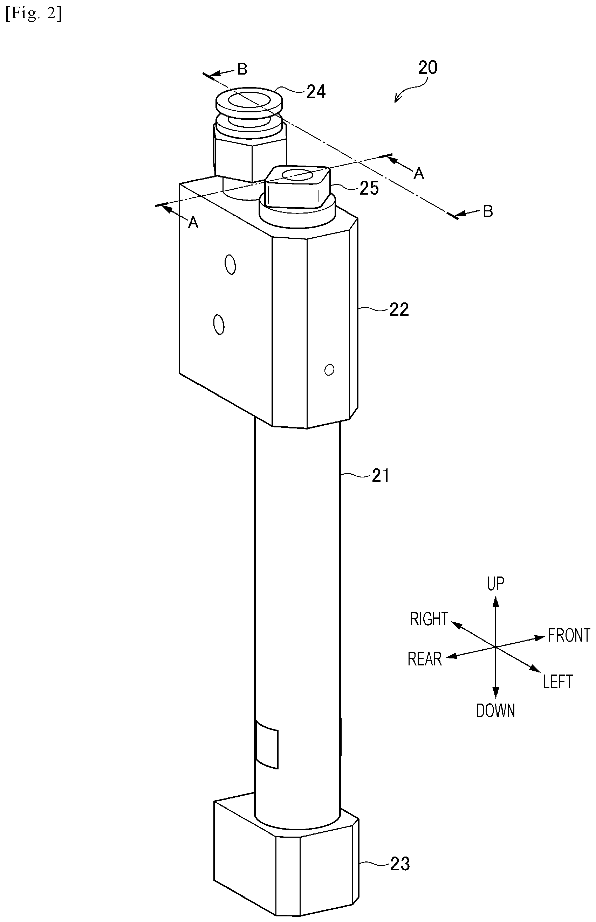

Fig. 2 illustrates an appearance of plasma generator 20. As illustrated in Fig. 2, plasma generator 20 includes main body 21, connection terminal attachment section 22, and nozzle case 23. Gas pipe connection terminal 24 for connecting a gas pipe (not illustrated) that supplies process gas and power cable connection terminal 25 to connect power cable 200 (see Fig. 4) are attached to connection terminal attachment section 22. In Figs. 2 to 7, when referring to the direction, the directions of arrows illustrated in each drawing are used.

As illustrated in Fig. 4, gas pipe connection terminal 24 is connected to a first end of gas passage 30 having an L-shaped shape provided within connection terminal attachment section 22, and a second end of gas passage 30 is connected to the peripheral wall of cable passage 31 to which power cable connection terminal 25 is connected. Accordingly, as illustrated in Fig. 3, hole 31a is formed in the peripheral wall. As illustrated in Fig. 4, the inner diameter of cable passage 31 is formed to be larger than the outer diameter of power cable 200, and cable passage 31 also functions as a passage for the process gas. Arrow A1 indicates a part of the flow of the process gas, and the process gas supplied from gas pipe connection terminal 24 flows into cable passage 31 via gas passage 30.

An upper end of cable passage 31 is connected to power cable connection terminal 25 as described above, and the lower end of cable passage 31 is connected to an upper end of gas passage 32 formed in main body 21. A lower end of gas passage 32 is connected to an upper end of reaction chamber 33 to generate plasma gas. A lower end of reaction chamber 33 is tapered and has the same diameter as plasma gas introduction port 41 of nozzle 40. Further, electrode 34 is provided in reaction chamber 33 to extend downward.

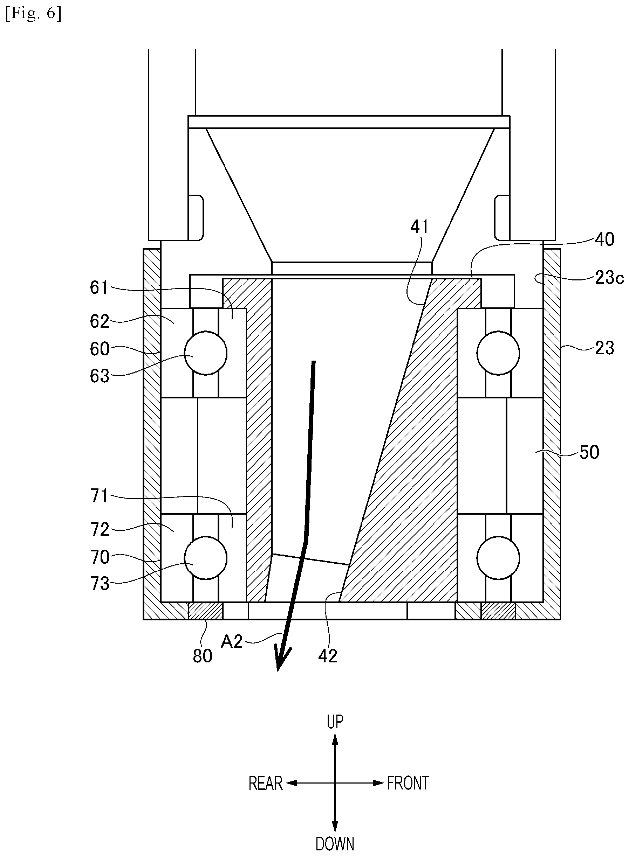

As illustrated in Fig. 6, cylindrical internal space 23c is formed in nozzle case 23, and nozzle 40, blade section 50, two bearings 60 and 70, and support member 80 are installed in internal space 23c. Two bearings 60 and 70 are made of an insulator, for example, ceramic, and nozzle case 23, nozzle 40, and blade section 50 are made of a conductor, for example, metal. Nozzle case 23 is grounded.

Nozzle 40 injects the plasma gas introduced into plasma gas introduction port 41 to the outside, and a lower end thereof is opened and functions as injection port 42. The diameter of injection port 42 is formed to be shorter than the diameter of plasma gas introduction port 41, and the center of injection port 42 is shifted outward from a position (the position is the same as the position of the central axis of internal space 23c) that extends vertically downward from the center of plasma gas introduction port 41 and that intersects a lower end surface of nozzle 40. This is because nozzle 40 is installed in internal space 23c to be rotatable about the central axis thereof and injects plasma gas from injection port 42 while rotating but at this time, a process target object is irradiated with the plasma gas over a wide range. Arrow A2 illustrates an example of a flow until the plasma gas introduced into plasma gas introduction port 41 of nozzle 40 is injected from injection port 42.

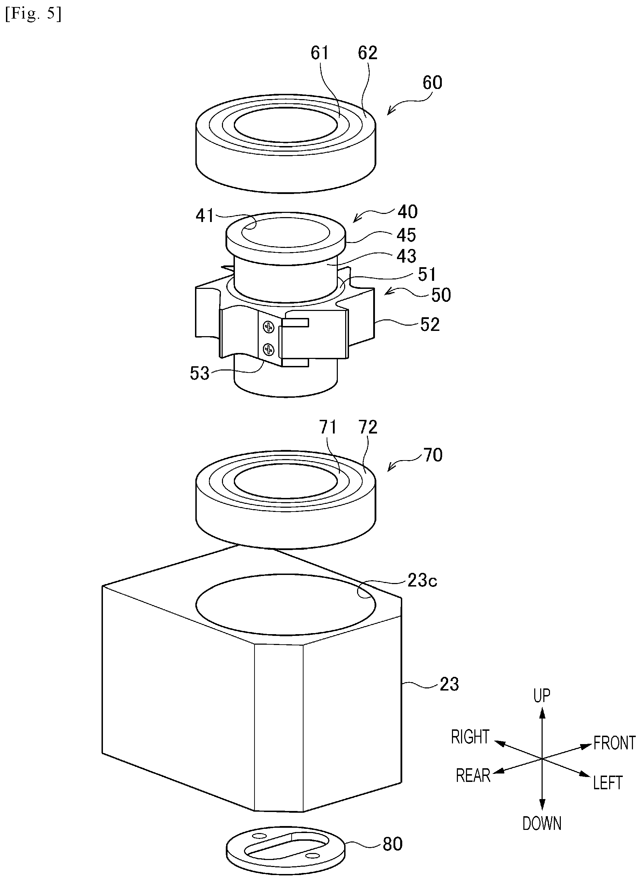

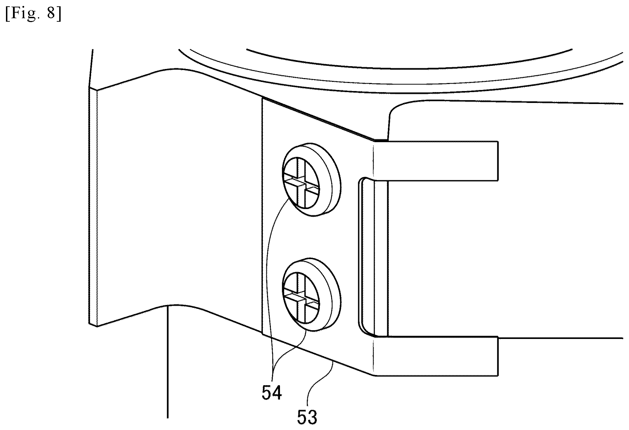

As illustrated in Fig. 5, blade section 50 is formed by forming a multiple of blades 52 on an outer peripheral surface of cylindrical main body 51. Each of blades 52 generates a rotational force in blade section 50 by receiving the air supplied and discharged by air supply/discharge device 92. Blade section 50 is attached to nozzle 40 by clamping the inner peripheral surface of main body 51 to the outer peripheral surface of trunk section 43 of nozzle 40. Further, metal contact plate 53 is attached to at least one of the multiple of blades 52 by, for example, metal screw 54 (see Fig. 8). Contact plate 53 is provided to be in contact with the inner peripheral surface of internal space 23c of nozzle case 23, and thus is attached at a position at which contact plate 53 is reliably in contact with the inner peripheral surface of internal space 23c is possible, for example, at a vicinity of the tip of blade 52. Further, although blade section 50 rotates, contact plate 53 is in contact with the inner peripheral surface of internal space 23c, so that it is preferable to use a material having a small contact resistance, for example, a spring steel having a biasing force.

Two bearings 60 and 70 are configured to support trunk section 43 of nozzle 40 as a shaft and to cause nozzle 40 to smoothly rotate. Bearing 60 is installed between the upper surface of blade section 50 and the lower surface of flange section 45 of nozzle 40, and bearing 70 is installed between the lower surface of blade section 50 and the lower end portion of trunk section 43 of nozzle 40.

Bearing 60 is a so-called ball bearing, and surrounds ball 63 (see Fig. 6) by inner ring 61 and outer ring 62. Similarly, bearing 70 is a ball bearing, and surrounds ball 73 (see Fig. 6) by inner ring 71 and outer ring 72.

Support member 80 is installed on the bottom surface of nozzle case 23 to support inner ring 71 of bearing 70.

Fig. 7 is a diagram illustrating a structure in which nozzle 40 installed in nozzle case 23 rotates. Air supply port 23a and air discharge port 23b are formed in a front and rear direction on the right side surface of nozzle case 23. A first end of an air pipe (not illustrated) is connected to air supply port 23a, and a second end of the air pipe is connected to air supply/discharge device 92. A first end of an air pipe (not illustrated) is also connected to air discharge port 23b, and a second end of the air pipe is connected to air supply/discharge device 92.

Air supply/discharge device 92 simultaneously supplies and discharges air, so that air is supplied from air supply/discharge device 92 to air supply port 23a as indicated by arrow A3, and the air is discharged from air discharge port 23b to air supply/discharge device 92 as indicated by arrow A4. As a result, as indicated by arrow A5, since a clockwise rotational force is applied to blade section 50, the same rotational force is also applied to nozzle 40 to which blade section 50 is clamped, so that nozzle 40 is rotated by bearings 60 and 70. Arrow A6 indicates a state in which blade section 50 rotates clockwise.

In plasma generator 20 configured as described above, controller 102 causes control circuit 104 to apply a voltage, at which a pseudo arc is generated from electrode 34, to electrode 34.

Further, controller 102 causes first drive circuit 106 to supply the process gas from process gas supply device 90 to gas passage 30 on the side of connection terminal attachment section 22. The process gas supplied to gas passage 30 is supplied to reaction chamber 33 through gas passage 32 on the side of main body 21. The process gas is converted into plasma in reaction chamber 33 and is injected from injection port 42 of nozzle 40 as plasma gas.

As described above, the plasma of the process gas is generated by generating a pseudo arc in reaction chamber 33 from electrode 34 and passing the process gas through the pseudo arc. The pseudo arc is generated between a pair of electrodes, but since only first electrode 34 is provided in plasma generator 20 of the present embodiment, nozzle 40 functions as an electrode and is used as a second electrode. In order to use nozzle 40 as an electrode, since a predetermined potential difference needs to be generated between electrode 34 and nozzle 40, it is necessary that nozzle 40 is grounded. Since nozzle case 23 is grounded as described above, it is necessary to form a conductive path between nozzle 40 and nozzle case 23. Therefore, in the present embodiment, conductive blade section 50 is clamped to nozzle 40, conductive contact plate 53 is attached to blade 52 of blade section 50 by conductive screw 54, and, by configuring contact plate 53 to be in contact with the inner peripheral surface of internal space 23c of nozzle case 23, a conductive path is formed between nozzle 40 and nozzle case 23.

In this way, a predetermined potential difference is generated between electrode 34 and nozzle 40, so that a pseudo arc is generated. However, when bearings 60 and 70 are also included in the formed conductive path, there is a problem that bearing damage, lubrication deterioration, or the like is generated or advances in bearings 60 and 70 due to electrolytic corrosion. Therefore, in the present embodiment, bearings 60 and 70 are made of only an insulating member, for example, ceramic, so that no current flows through bearings 60 and 70.

Meanwhile, controller 102 causes second drive circuit 108 to supply air from air supply/discharge device 92 to air supply port 23a and discharge the air from air discharge port 23b. As a result, each of blades 52 receives the air supplied and discharged by air supply/discharge device 92 to generate a rotational force in blade section 50, so that nozzle 40 rotates, and the plasma gas injected from injection port 42 are irradiated over a wide range.

As described above, the plasma generation device of the present embodiment includes one electrode 34, nozzle case 23 made of a conductor and having cylindrical internal space 23c, nozzle 40 made of a conductor, installed rotatably about a central axis of internal space 23c of nozzle case 23, and configured to eject generated plasma gas, air supply/discharge device 92 configured to supply air into internal space 23c, bearings 60 and 70 made of an insulator and configured to rotate nozzle 40 from the air supplied by air supply/discharge device 92, the conductive path formed between nozzle case 23 and nozzle 40, and control circuit 104 that applies a voltage to electrode 34, in which nozzle case 23 is grounded, and the plasma gas is generated by a potential difference between electrode 34 to which a voltage is applied by control circuit 104 and nozzle 40 grounded to the conductive path.

As described above, in plasma generation device 1 of the present embodiment, although a voltage is applied to electrode 34 when the plasma gas is generated, no current flows through bearings 60 and 70, and no electrolytic corrosion is generated, so that the lifespan of bearings 60 and 70 is extended, and ultimately it is possible to extend the product lifespan of plasma generation device 1.

In the present embodiment, the air is an example of a "fluid". Air supply/discharge device 92 is an example of a "fluid supply device". Bearings 60 and 70 are an example of a "rotation mechanism". Control circuit 104 is an example of a "power supply".

Further, the outer peripheral surface of nozzle 40 has a cylindrical shape, bearings 60 and 70 are bearings 60 and 70 made of an insulator and pivotally support the outer peripheral surface of nozzle 40 as a shaft, blade section 50 made of a conductor and having blade 52 that receives the air supplied into internal space 23c is clamped to the outer peripheral surface of nozzle 40, and nozzle 40 is rotated when blade 52 receiving the air supplied to internal space 23c generates a rotational force in blade section 50 and the rotational force is transmitted to nozzle 40.

Further, blade section 50 has contact plate 53 made of a conductor and being in contact with the wall surface that forms internal space 23c of nozzle case 23, and the conductive path is a path that connects nozzle 40, blade section 50, contact plate 53, and the wall surface that forms internal space 23c of nozzle case 23.

Further, contact plate 53 is made of spring steel. As a result, it is possible to reduce contact resistance when nozzle 40 rotates.

Further, nozzle case 23 having a cylindrical internal space, air supply port 23a to supply external air into internal space 23c, and air discharge port 23b that discharges the air in internal space 23c, nozzle 40 that is rotatably installed about a central axis of internal space 23c of nozzle case 23 and that is configured to eject generated plasma gas, and air supply/discharge device 92 configured to supply the air to air supply port 23a and to discharge the air from air discharge port 23b are included, in which nozzle 40 has plasma gas introduction port 41 through which the generated plasma gas is introduced into nozzle 40 and injection port 42 having a smaller diameter than plasma gas introduction port 41 and injecting the introduced plasma gas to the outside, injection port 42 is formed at a position deviated from the central axis of internal space 23c, and air supply/discharge device 92 rotates nozzle 40 by supplying the air from air supply port 23a into internal space 23c and discharging the air in internal space 23c from air discharge port 23b.

As described above, in plasma generation device 1 of the present embodiment, nozzle 40 is rotated by supplying the air from air supply port 23a into internal space 23c and discharging the air in internal space 23c from air discharge port 23b, so that it is possible to rotate nozzle 40 in a fast and stable manner.

The present invention is not limited to the embodiment described above, and various modifications can be made without departing from the gist thereof.
(1) In the embodiment described above, air supply/discharge device 92 is configured to both supply and discharge the air into and from internal space 23c of nozzle case 23, but may be configured to only perform one of these functions. Further, the gas included in the fluid is not limited to the "air" employed in the embodiment described above, but may be another type of gas, or may be a liquid instead of the gas.
(2) In the embodiment described above, ball bearings are used as bearings 60 and 70; however, but the configuration is not limited to this, and bearings of another structure may be employed. However, the configuration is limited to the structure configured with an insulator. This is because a problem of electrolytic corrosion occurs.
(3) In the embodiment described above, only the process gas is supplied to reaction chamber 33, but inert gas may also be supplied in a superimposed manner.

### Reference Signs List

1: plasma generation device, 20: plasma generator, 23: nozzle case, 23a: air supply port, 23b: air discharge port, 23c: internal space, 34: electrode, 40: nozzle, 42: injection port, 50: blade section, 52: blade, 53: contact plate, 60, 70: bearing, 90: process gas supply device, 92: air supply/discharge device.

## Claims

1. A plasma generation device comprising:
one electrode;
a nozzle case made of a conductor and having a cylindrical internal space;
a nozzle made of a conductor, installed rotatably about a central axis of the internal space of the nozzle case, and configured to eject a generated plasma gas;
a fluid supply device configured to supply a fluid into the internal space;
a rotation mechanism made of an insulator and configured to rotate the nozzle by the fluid supplied from the fluid supply device;
a conductive path formed between the nozzle case and the nozzle; and
a power supply configured to apply a voltage to the electrode, wherein
the nozzle case is grounded, and
the plasma gas is generated by a potential difference between the electrode to which a voltage is applied by the power supply and the nozzle grounded by the conductive path.

2. The plasma generation device according to claim 1, wherein
the nozzle has a cylindrical outer peripheral surface,
the rotation mechanism is a bearing made of an insulator and pivotally supports the outer peripheral surface of the nozzle as a shaft,
a blade section made of a conductor and having a blade configured to receive the fluid supplied into the internal space is clamped to the outer peripheral surface of the nozzle, and
the nozzle is rotated when the blade receiving the fluid supplied to the internal space generates a rotational force in the blade section and the rotational force is transmitted to the nozzle.

3. The plasma generation device according to claim 2, wherein
the blade section has a contact plate made of a conductor and being in contact with a wall surface that forms the internal space of the nozzle case, and
the conductive path is a path that connects the nozzle, the blade section, the contact plate, and the wall surface that forms the internal space of the nozzle case.

4. The plasma generation device according to claim 3, wherein
the contact plate is made of spring steel.

5. A plasma generation device comprising:
a nozzle case having a cylindrical internal space, a fluid supply port to supply a fluid into the internal space, and a fluid discharge port configured to discharge the fluid in the internal space;
a nozzle that is rotatably installed about a central axis of the internal space of the nozzle case and that is configured to eject a generated plasma gas; and
a fluid supply/discharge device configured to supply the fluid to the fluid supply port and to discharge the fluid from the fluid discharge port, wherein
the nozzle has an introduction port through which the generated plasma gas is introduced into the nozzle and an injection port through which the introduced plasma gas is ejected to an outside,
the injection port is formed at a position deviated from the central axis of the internal space, and
the fluid supply/discharge device rotates the nozzle by supplying the fluid from the fluid supply port into the internal space and discharging the fluid in the internal space from the fluid discharge port.
